# EUROPEAN PATENT APPLICATION

(11) **EP 4 191 654 A1**
(43) Date of publication of application: **07.06.2023**
(21) Application number: 22200053.1
(22) Date of filing: 06.10.2022
(51) Int. Cl.: H01L 21/822, H01L 21/8234, H01L 29/66, H01L 21/8238

(54) **METHODS OF FORMING INTEGRATED CIRCUIT DEVICES INCLUDING STACKED TRANSISTORS AND INTEGRATED CIRCUIT DEVICES FORMED BY THE SAME**

(30) Priority: 02.12.2021 US 202163285135 P; 22.02.2022 US 202217677329
(71) Applicant: Samsung Electronics Co., Ltd., Gyeonggi-do 16677 (KR)
(72) Inventor: HE, Ming, San Jose, CA 95134 (US); HA, Daewon, San Jose, CA 95134 (US); SIMKA, Harsono, San Jose, CA 95134 (US); PARK, Jaehyun, San Jose, CA 95134 (US); SAREMI, Mehdi, San Jose, CA 95134 (US); PARK, Rebecca, San Jose, CA 95134 (US)
(74) Representative: Kuhnen & Wacker Patent- und Rechtsanwaltsbüro PartG mbB

(57) **Abstract**

Methods of forming the integrated circuit device are provided. The methods include providing a preliminary transistor stack including an upper sacrificial layer on a substrate, an upper active region between the substrate and the upper sacrificial layer, a lower sacrificial layer between the substrate and the upper active region, and a lower active region between the substrate and the lower sacrificial layer. The methods further include forming lower source/drain regions on respective opposing side surfaces of the lower active region, forming a capping layer on a first lower source/drain region of the lower source/drain regions, the capping layer including an insulating material, and forming upper source/drain regions on respective opposing side surfaces of the upper active region.

## Description

### FIELD

The present disclosure generally relates to the field of electronics and, more particularly, to integrated circuit devices including stacked transistors.

### BACKGROUND

An integrated circuit device including stacked transistors, such as a complementary field effect transistor (CFET) stack, was introduced to reduce an area thereof to close to one-half of the area of a corresponding non-stacked device. Stacked transistors include conductive elements vertically stacked, and achieving electrical isolation between those stacked conductive elements may increase difficulty and complexity of manufacturing processes.

### SUMMARY

The invention is defined in the appended claims.

According to some embodiments of the present inventive concept, methods of forming an integrated circuit device may include providing a preliminary transistor stack including an upper sacrificial layer on a substrate, an upper active region between the substrate and the upper sacrificial layer, a lower sacrificial layer between the substrate and the upper active region, and a lower active region between the substrate and the lower sacrificial layer. The methods may also include forming lower source/drain regions on respective opposing side surfaces of the lower active region, forming a preliminary capping layer on a first lower source/drain region of the lower source/drain regions, the preliminary capping layer including a semiconductor material, converting the preliminary capping layer to a capping layer that includes an insulating material, and forming upper source/drain regions on respective opposing side surfaces of the upper active region.

According to some embodiments of the present inventive concept, methods of forming an integrated circuit device may include providing a preliminary transistor stack including an upper sacrificial layer on a substrate, an upper active region between the substrate and the upper sacrificial layer, a lower sacrificial layer between the substrate and the upper active region, and a lower active region between the substrate and the lower sacrificial layer. The methods may also include forming lower source/drain regions on respective opposing side surfaces of the lower active region, forming a capping layer on a first lower source/drain region of the lower source/drain regions, and forming upper source/drain regions on respective opposing side surfaces of the upper active region. The capping layer may include an insulating material. The capping layer may contact a portion of a surface of the first lower source/drain region of the lower source/drain regions and may have a uniform thickness along the portion of the surface of the first lower source/drain region of the lower source/drain regions.

According to some embodiments of the present inventive concept, integrated circuit devices may include an upper transistor on a substrate and a lower transistor between the substrate and the upper transistor. The upper transistor may include an upper active region and an upper source/drain region contacting a side surface of the upper active region. The lower transistor may include a lower active region and a lower source/drain region contacting a side surface of the lower active region. The integrated circuit devices may also include a capping layer including an insulating material. The capping layer may contact a portion of a surface of the lower source/drain region and may have a uniform thickness along the portion of the surface of the lower source/drain region.

### BRIEF DESCRIPTION OF THE DRAWINGS

FIG. 1 is a flow chart of methods of forming an integrated circuit device according to some embodiments of the present invention.
FIGS. 2A, 2B, 3 through 11, 12A, 12B, 13A, 13B, 14A, 14B, 15A, 15B, 16A, 16B, 17A, 17B and 18 are views illustrating methods of forming an integrated circuit device according to some embodiments of the present invention.

### DETAILED DESCRIPTION

Stacked transistors may include a lower source/drain region and an upper source/drain region, which are vertically stacked. An isolation layer between those source/drain regions may be formed by deposition of an insulating layer on the lower source/drain region, and then an etch process may be performed to partially remove the insulating layer so as to expose an element of an upper transistor (e.g., an active region of the upper transistor). The etch process should be controlled precisely to reduce defects. If the insulating layer is etched excessively, the insulating layer may expose the lower source/drain region, and the lower source/drain region may be electrically connected to the upper source/drain that is subsequently formed. On the other hand, if the insulating layer is not etched enough, the insulating layer may not expose an element of the upper transistor, and thus subsequent processes using an exposed portion of the element cannot be performed.

According to example embodiments of the present invention, an isolation layer may be selectively formed between a lower source/drain region and an upper source/drain region. Accordingly, an etch process that should be controlled precisely may be omitted.

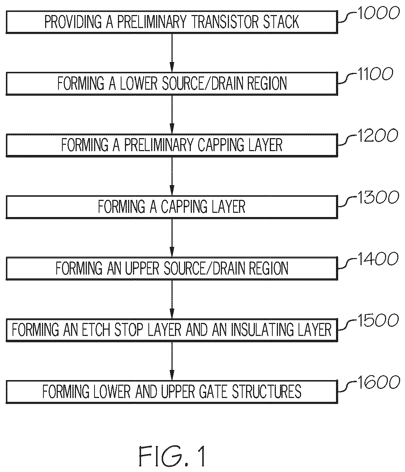

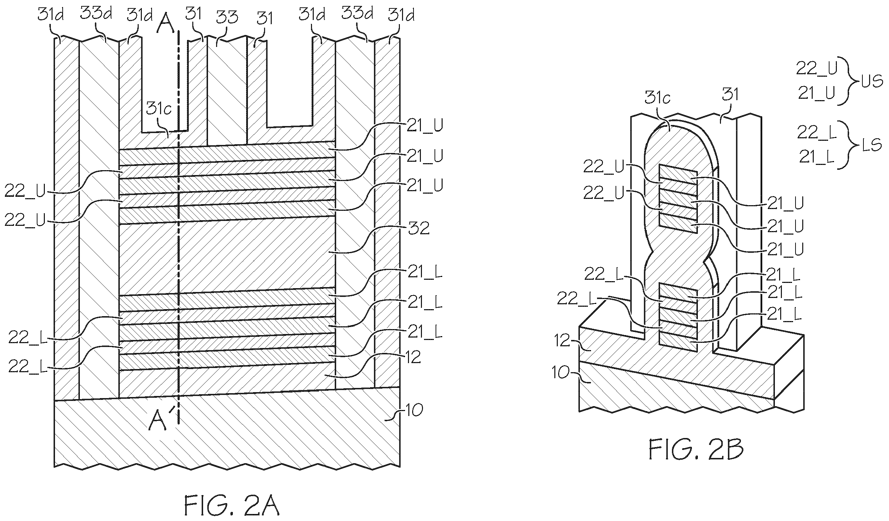

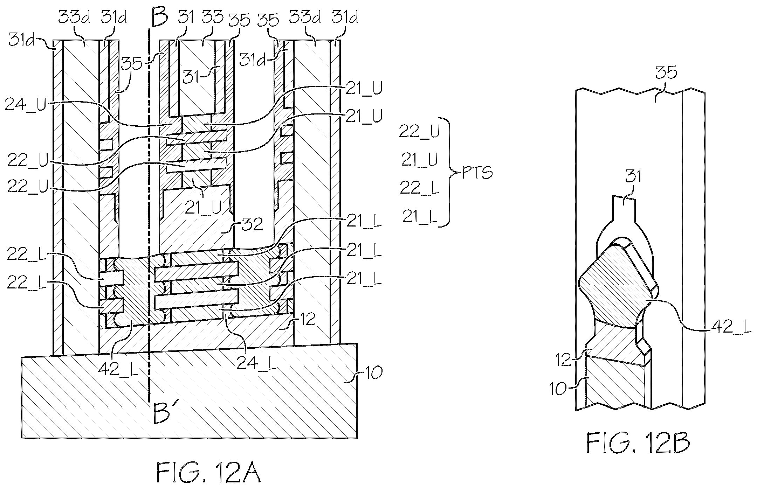

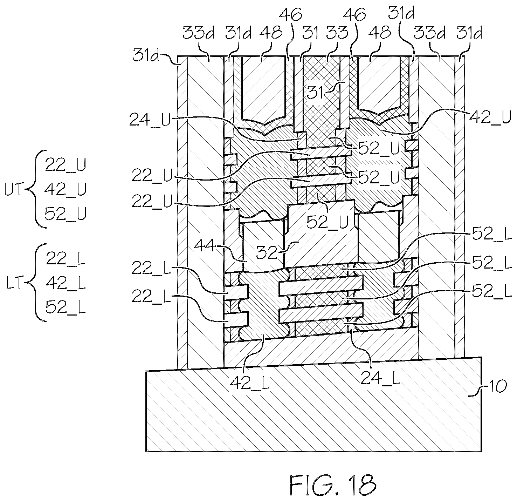

FIG. 1 is a flow chart of methods of forming an integrated circuit device according to some embodiments of the present invention. FIGS. 2A, 2B, 3 through 11, 12A, 12B, 13A, 13B, 14A, 14B, 15A, 15B, 16A, 16B, 17A, 17B and 18 are views illustrating methods of forming an integrated circuit device according to some embodiments of the present invention. FIG. 2A is a side perspective view of an integrated circuit device showing a cross-section taken along a channel length direction of a transistor (e.g., a lower transistor LT or an upper transistor UT in FIG. 18), and FIGS. 2B and 3 through 11 are side perspective views showing cross-sections taken along the line A-A' in FIG. 2A. FIGS. 12A, 13A, 14A, 15A, 16A, 17A and 18 are side perspective views showing cross-sections taken along the channel length direction, and FIGS. 12B, 13B, 14B, 15B, 16B and 17B are side perspective views showing cross-sections taken along the line B-B' in FIG. 12A.

Referring to FIG. 1, the methods may include providing a preliminary transistor stack (e.g., PTS in FIG. 12A) (Block 1000). The preliminary transistor stack may be formed by processes illustrated in FIGS. 2A, 2B and 3 through 11.

Referring to FIGS. 2A and 2B, a lower stack LS including lower sacrificial layers 21_L and lower active regions 22_L, which are alternately stacked, may be provided on a substrate 10, a gate isolation layer 32 may be provided on the lower stack LS, and an upper stack US including upper sacrificial layers 21_U and upper active regions 22_U, which are alternately stacked, may be provided on the gate isolation layer 32. Although FIGS. 2A and 2B illustrate that each of the lower stack LS and the upper stack US includes three sacrificial layers and two active regions, the present invention is not limited thereto. Each of the lower stack LS and the upper stack US may include any number of sacrificial layers and active regions.

The substrate 10 may include one or more semiconductor materials, for example, Si, Ge, SiGe, GaP, GaAs, SiC, SiGeC and/or InP. In some embodiments, the substrate 10 may be a bulk substrate (e.g., a bulk silicon substrate) or a semiconductor on insulator (SOI) substrate.

The lower sacrificial layers 21_L may include a material different from the lower active regions 22_L such that the lower sacrificial layers 21_L can have an etch selectivity with respect to the lower active regions 22_L. The upper sacrificial layers 21_U may include a material different from the upper active regions 22_U such that the upper sacrificial layers 21_U can have an etch selectivity with respect to the upper active regions 22_U. For example, each of the lower sacrificial layers 21_L and the upper sacrificial layers 21_U may be a silicon germanium layer, and each of the lower active regions 22_L and the upper active regions 22_U may be a silicon layer. In some embodiments, the lower active regions 22_L and the upper active regions 22_U may include different materials from each other to increase carrier mobility thereof.

In some embodiments, each of the lower active regions 22_L and the upper active regions 22_U may be a nanosheet that may have a thickness in a range of from 1 nm to 100 nm. In some embodiments, each of the lower active regions 22_L and the upper active regions 22_U may be a nanowire that may have a radius in a range of from 1 nm to 100 nm.

The gate isolation layer 32 may include one or more of various insulating materials. For example, the gate isolation layer 32 may include silicon oxide, silicon nitride, silicon oxynitride and/or low k material. The low k material may include, for example, fluorine-doped silicon dioxide, organosilicate glass, carbon-doped oxide, porous silicon dioxide, porous organosilicate glass, spin-on organic polymeric dielectric, or spin-on silicon based polymeric dielectric.

Stack spacers 31 and a stack capping layer 33 may be provided on the upper stack US. The stack capping layer 33 may be between the stack spacers 31. The stack spacers 31 and the stack capping layer 33 may include different materials. The stack spacers 31 may include, for example, silicon nitride, silicon oxynitride, silicon carbide and/or silicon carbonitride, and the stack capping layer 33 may include, for example, amorphous silicon and/or polysilicon and may optionally include impurities (e.g., boron, aluminum, gallium, indium, phosphorus, and/or arsenic). In some embodiments, the stack spacers 31 may each be a silicon nitride layer, and the stack capping layer 33 may be an amorphous silicon layer.

Dummy stack spacers 31d and a dummy stack capping layer 33d may be provided on the substrate 10. The dummy stack spacer 31d and the stack spacer 31 may be connected through a connecting portion 31c of the stack spacer 31 as illustrated in FIG 2A. The dummy stack spacers 31d may include the same material as the stack spacers 31, and the dummy stack capping layer 33d may include the same material as the stack capping layer 33. In some embodiments, the dummy stack spacers 31d and the dummy stack capping layer 33d may be omitted.

In some embodiments, a bottom isolation layer 12 may be provided between the substrate 10 and the lower stack LS as illustrated in FIG. 2A to reduce leakage current through the substrate 10. The bottom isolation layer 12 may include silicon oxide, silicon nitride, silicon oxynitride and/or low k material. In some embodiments, the bottom isolation layer 12 may be omitted and the lower stack LS may contact the substrate 10.

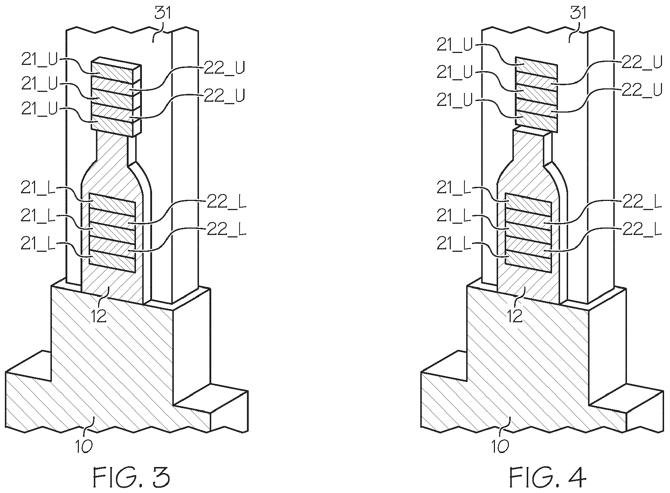

Referring to FIG. 3, the stack spacers 31 may be etched such that the upper stack US may protrude outward from the stack spacer 31. In some embodiments, the stack spacers 31 may be etched by a dry etch process and/or a wet etch process without an etch mask. In some embodiments, portions of the substrate 10 and the bottom isolation layer 12, which are not covered by the stack spacers 31, may be etched while etching the stack spacers 31, and a recess may be formed in the substrate 10.

Referring to FIG. 4, a portion of the upper stack US protruding outward from the stack spacer 31 may be recessed by an etch process (e.g., a dry etch and/or a wet etch process).

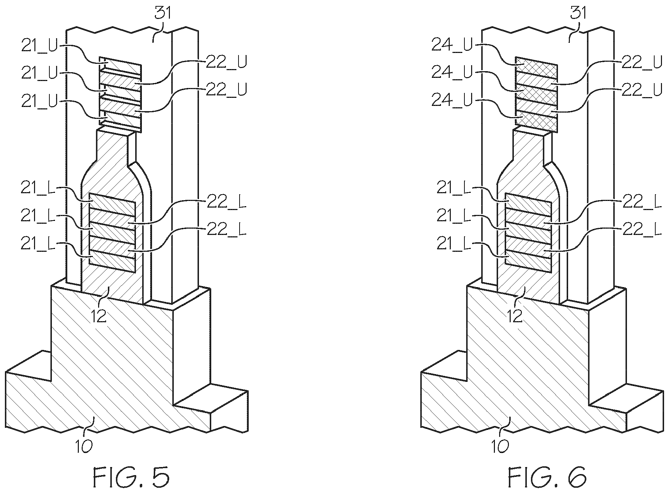

Referring to FIG. 5, portions of the upper sacrificial layers 21_U may be removed by an etch process (e.g., a dry etch process and/or a wet etch process) such that the upper sacrificial layers 21_U may be recessed relative to the upper active regions 22_U and the stack spacer 31. Accordingly, upper recesses may be formed in the stack spacer 31. Etchant(s) and process conditions for the etch process may be selected to selectively etch the portions of the upper sacrificial layers 21_U with respect to the upper active regions 22_U and the stack spacer 31.

Referring to FIG. 6, upper inner spacers 24_U may be formed in the upper recesses, respectively. The upper inner spacers 24_U may contact the upper sacrificial layers 21_U, respectively. The upper inner spacers 24_U may include a material different from the upper sacrificial layers 21_U. The upper inner spacers 24_U may include, for example, silicon nitride, silicon oxynitride, silicon carbide and/or silicon carbonitride. In some embodiments, an upper spacer layer may be formed in the upper recesses and on an outer surface of the stack spacer 31, and then a portion of the upper spacer layer formed on the outer surface of the stack spacer 31 may be removed, thereby forming the upper inner spacers 24_U.

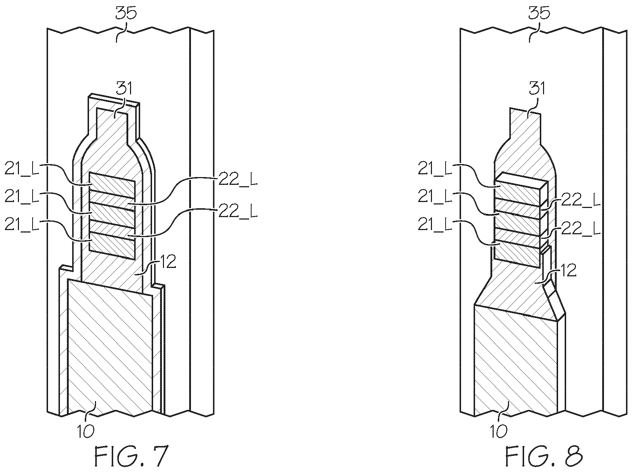

Referring to FIG. 7, gate liner layers 35 may be formed on the structure illustrated in FIG. 6 by a conformal deposition process (e.g., an atomic layer deposition (ALD) process or a chemical vapor deposition (CVD) process). The gate liner layers 35 may have a uniform thickness on a surface of the structure illustrated in FIG. 6. The gate liner layers 35 may include, for example, silicon nitride, silicon oxynitride, silicon carbide and/or silicon carbonitride. In some embodiments, the gate liner layers 35 may each be a silicon nitride layer.

Referring to FIG. 8, the gate liner layers 35 may be removed by an etch process (e.g., a dry etch process and/or a wet etch process) and portions of the stack spacers 31 not covered by the gate liner layers 35 may be etched such that the lower stack LS may protrude outward from the stack spacer 31. In some embodiments, the gate liner layers 35 and the portions of the stack spacers 31 may be etched without an etch mask. Etchant(s) and process conditions for the etch process may be selected to selectively etch the gate liner layers 35 and the stack spacers 31 with respect to the lower stack LS. In some embodiments, the gate liner layers 35 may be removed by an anisotropic etch process such that portions of the gate liner layers 35 formed on sidewalls of elements (e.g., the upper active regions 22_U) may not be etched. Accordingly, in some embodiments, the gate liner layers 35 may be left and cover sidewalls of the upper active regions 22_U after the gate liner layers 35 is removed by the process illustrated in FIG. 8.

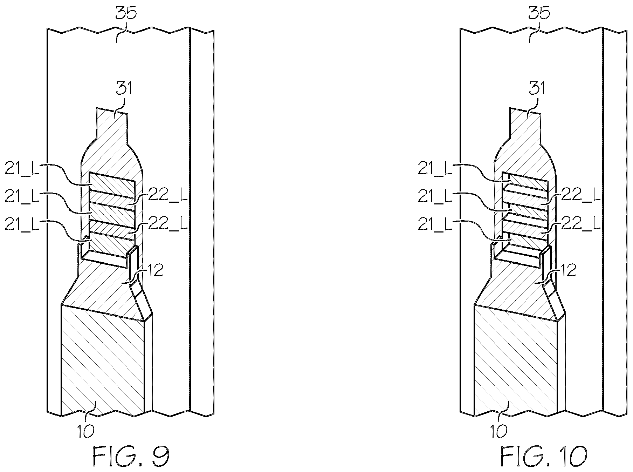

Referring to FIG. 9, a portion of the lower stack LS protruding outward from the stack spacers 31 may be recessed by an etch process (e.g., a dry etch and/or a wet etch process).

Referring to FIG. 10, portions of the lower sacrificial layers 21_L may be removed by an etch process (e.g., a dry etch process and/or a wet etch process) such that the lower sacrificial layers 21_L may be recessed relative to the lower active regions 22_L and the stack spacer 31. Accordingly, lower recesses may be formed in the stack spacer 31. Etchant(s) and process conditions for the etch process may be selected to selectively etch the portions of the lower sacrificial layers 21_L with respect to the lower active regions 22_L and the stack spacer 31.

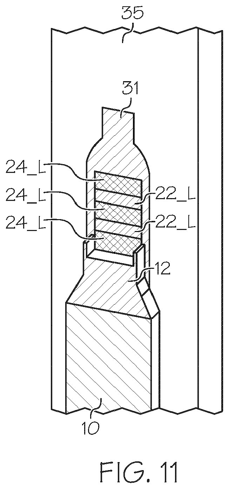

Referring to FIG. 11, lower inner spacers 24_L may be formed in the lower recesses, respectively. The lower inner spacers 24_L may contact the lower sacrificial layers 21_L, respectively. The lower inner spacers 24_L may include a material different from the lower sacrificial layers 21_L. The lower inner spacers 24_L may include, for example, silicon nitride, silicon oxynitride, silicon carbide and/or silicon carbonitride. In some embodiments, a lower spacer layer may be formed in the lower recesses and on an outer surface of the stack spacer 31, and then a portion of the lower spacer layer formed on the outer surface of the stack spacer 31 may be removed, thereby forming the lower inner spacers 24_L.

Referring to FIGS. 1, 12A and 12B, lower source/drain regions 42_L may be formed on respective opposing side surfaces of each of the lower active regions 22_L (Block 1100). The lower source/drain regions 42_L may contact the opposing side surfaces of each of the lower active regions 22_L, respectively. In some embodiments, the lower source/drain regions 42_L may be formed by performing an epitaxial growth process using the lower active regions 22_L as a seed layer. The gate liner layers 35 cover the upper active regions 22_U, and thus an epitaxial layer does not grow from the upper active regions 22_U while forming the lower source/drain regions 42_L. The lower source/drain regions 42_L may include, for example, silicon or silicon germanium. In some embodiments, the lower source/drain regions 42_L may include silicon germanium.

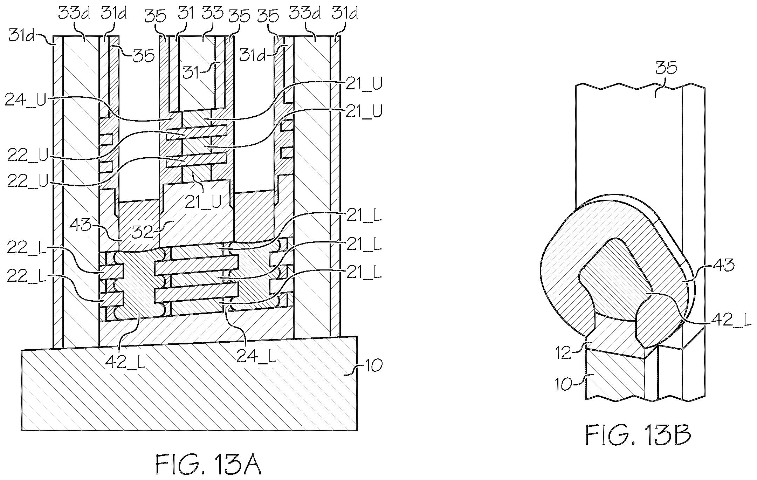

Referring to FIGS. 1, 13A and 13B, preliminary capping layers 43 may be formed on the lower source/drain regions 42_L, respectively (Block 1200). The preliminary capping layers 43 may be formed by performing an epitaxial growth process using the lower source/drain regions 42_L as a seed layer, and each of the preliminary capping layers 43 may include a portion that contacts a surface of the lower source/drain region 42_L and has a uniform thickness along the surface of the lower source/drain region 42_L, as illustrated in FIG. 13B, when viewed in cross section taken along a direction perpendicular to the channel length direction. The preliminary capping layers 43 may include, for example, silicon or silicon germanium.

In some embodiments, the lower source/drain regions 42_L and the preliminary capping layers 43 may be formed by a single epitaxial growth process and may include the same material. Accordingly, in some embodiments, an interface between the lower source/drain region 42_L and the preliminary capping layer 43 may not be visible.

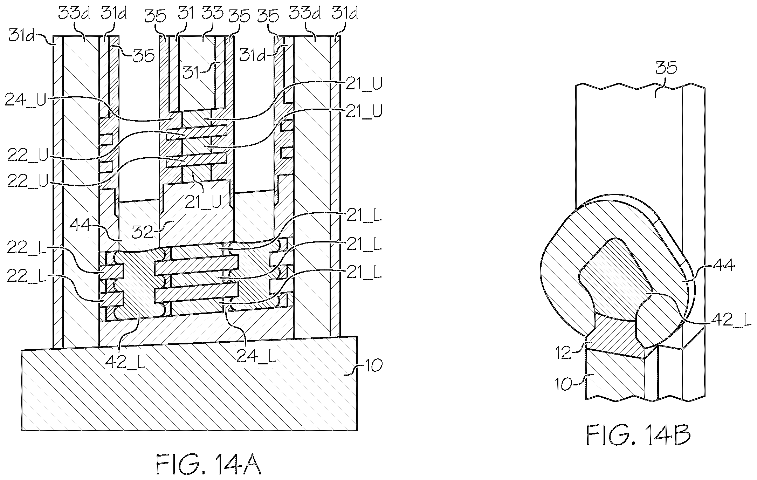

Referring to FIGS. 1, 14A and 14B, capping layers 44 may be formed on the lower source/drain regions 42_L, respectively (Block 1300). The capping layers 44 may include a silicon oxide layer, a silicon oxynitride layer, a silicon nitride layer, a silicon germanium nitride layer or a germanium nitride layer.

The capping layers 44 may be formed by converting the preliminary capping layers 43 to the capping layers 44. The preliminary capping layers 43 may be converted by an oxidation process and/or a nitridation process performed on the preliminary capping layers 43. The oxidation process and/or the nitridation process may include, for example, a plasma oxidation and/or a plasma nitridation using a gas comprising oxygen, nitrogen and/or ammonia.

In some embodiments, the preliminary capping layers 43 may each be a silicon layer, and the silicon layer may be converted to a silicon oxide layer by an oxidation process (e.g., a plasma oxidation process using a gas including oxygen or a thermal oxidation process). For example, a thermal oxidation process may be performed at a temperature in a range of from about 100 C° to about 1100 C°. The silicon layer may be converted to a silicon oxynitride layer or a silicon nitride layer by an oxidation process and a nitridation process, which are performed concurrently. For example, a plasma process using a gas including oxygen, nitrogen and/or ammonia or a thermal process using a gas including oxygen, nitrogen and/or ammonia may be performed to convert a silicon layer to a silicon oxynitride layer or a silicon nitride layer.

In some embodiments, the preliminary capping layers 43 may each be a silicon germanium layer having a germanium concentration in a range of from about 0.01 at % to about 50 at %, and the silicon germanium layer may be converted to a silicon oxide layer by an oxidation process (e.g., a germanium condensation process). The silicon germanium layer may be converted to a silicon germanium nitride layer by a nitridation process (e.g., a plasma nitridation process using a gas including nitrogen and/or ammonia) or may be converted to a germanium nitride layer by a nitridation process in which process conditions are set to allow diffusion of silicon into the lower source/drain regions 42_L while performing the nitridation process.

In some embodiments, the capping layer 44 may include a portion that contacts a surface of the lower source/drain region 42_L and has a uniform thickness along the surface of the lower source/drain region 42_L, as illustrated in FIG. 14B, when viewed in cross section taken along a direction perpendicular to the channel length direction.

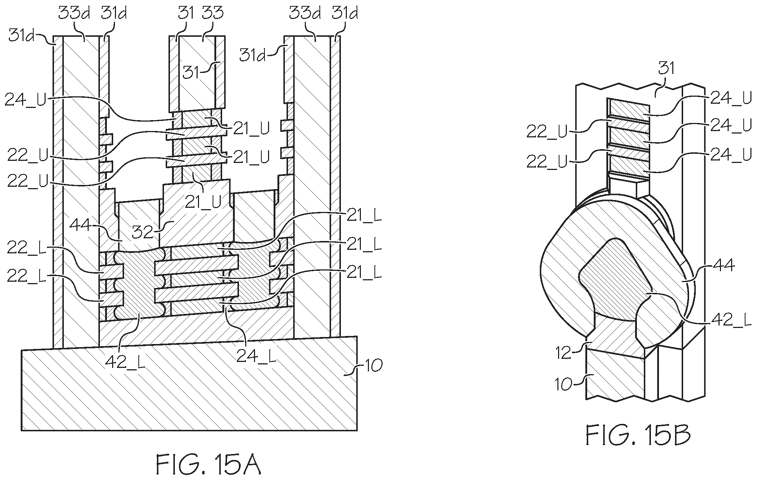

Referring to FIGS. 15A and 15B, the gate liner layer 35 may be removed to expose the upper active regions 22_U. The gate liner layer 35 may be removed by an etch process (e.g., a dry etch process and/or a wet etch process), and etchant(s) and process conditions may be selected to selectively etch the gate liner layer 35 with respect to the capping layers 44.

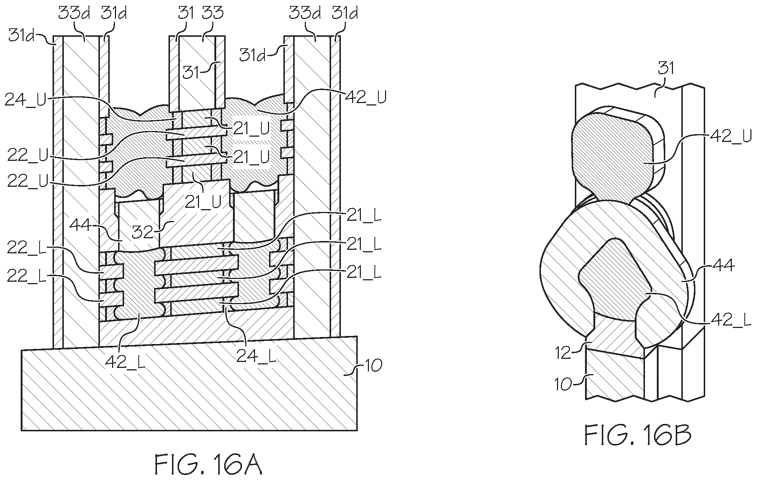

Referring to FIGS. 1, 16A and 16B, upper source/drain regions 42_U may be formed on the capping layers 44, respectively (Block 1400). In some embodiments, the upper source/drain regions 42_U may contact the respective capping layers 44. In some embodiments, the upper source/drain regions 42_U may be formed by performing an epitaxial growth process using the upper active regions 22_U as a seed layer. The upper source/drain regions 42_U may include, for example, silicon or silicon germanium. In some embodiments, the upper source/drain regions 42_U may include silicon.

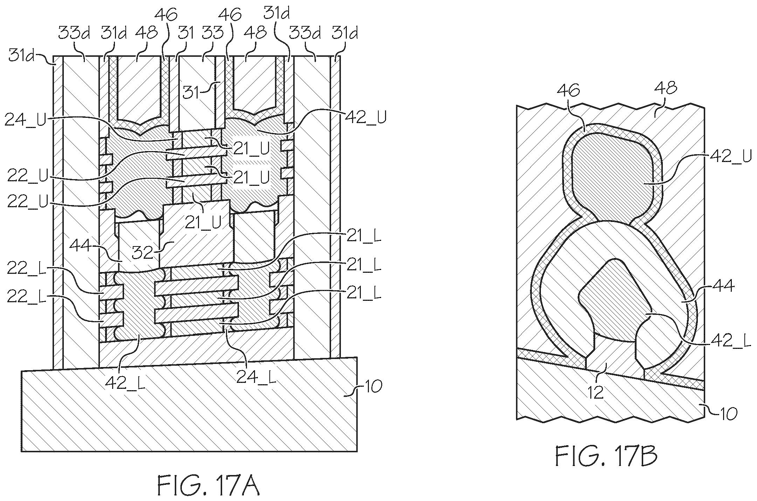

Referring to FIGS. 1, 17A and 17B, an etch stop layer 46 and an insulating layer 48 may be formed (Block 1500). For example, the etch stop layer 46 may be formed by a conformal deposition process (e.g., an ALD process or a CVD process), and the insulating layer 48 may be formed by a deposition process (e.g., an ALD process, a CVD process or a physical vapor deposition (PVD) process). In some embodiments, the etch stop layer 46 may continuously extend from the capping layer 44 to the upper source/drain region 42_U as illustrated in FIG. 17B and may contact the capping layer 44 and the upper source/drain region 42_U. In some embodiments, the etch stop layer 46 may have a uniform thickness on a surface of the capping layer 44 and on a surface of the upper source/drain region 42_U as illustrated in FIG. 17B.

In some embodiments, the etch stop layer 46 may include a material different from the capping layer 44. The etch stop layer 46 may include, for example, silicon nitride, silicon oxynitride, silicon carbide and/or silicon carbonitride. In some embodiments, the etch stop layer 46 may be a silicon nitride layer. In some embodiments, the insulating layer 48 may include a material different from the etch stop layer 46. The insulating layer 48 may include, for example, silicon oxide, silicon nitride, silicon oxynitride and/or low k material. In some embodiments, the insulating layer 48 may be a silicon oxide layer.

Referring to FIGS. 1 and 18, a lower gate structure 52_L and an upper gate structure 52_U may be formed (Block 1600). The lower gate structure 52_L may be formed by replacing the lower sacrificial layers 21_L with a lower gate insulator and a lower gate electrode, and the upper gate structure 52_U may be formed by replacing the upper sacrificial layers 21_U with an upper gate insulator and an upper gate electrode. For example, the lower sacrificial layers 21_L may be removed by an etch process (e.g., a dry etch process and/or a wet etch process), thereby forming lower openings, and then the lower gate insulator and the lower gate electrode may be formed in the lower openings by deposition processes. The upper sacrificial layers 21_U may be removed by an etch process (e.g., a dry etch and/or a wet etch process), thereby forming upper openings, and then the upper gate insulator and the upper gate electrode may be formed in the upper openings by deposition processes.

The lower gate insulator may extend between the lower active region 22_L and the lower gate electrode, and the upper gate insulator may extend between the upper active region 22_U and the upper gate electrode. Each of the gate insulators (e.g., the lower gate insulator and/or the upper gate insulator) may include an interfacial layer (e.g., a silicon oxide layer) and a high-k material layer, and each of the gate electrodes (e.g., the lower gate electrode and/or the upper gate electrode) may include multiple layers including a barrier layer, a work function layer and/or a metal layer. The high-k material layer may include hafnium silicate, zirconium silicate, hafnium dioxide and/or zirconium dioxide.

In some embodiments, a lower transistor LT that includes the lower active region 22_L, the lower source/drain region 42_L, and the lower gate structure 52_L may be a first conductivity type transistor (e.g., a P-type transistor), an upper transistor UT that includes the upper active region 22_U, the upper source/drain region 42_U, and the upper gate structure 52_U may be a second conductivity type transistor (e.g., an N-type transistor), and the lower transistor LT and the upper transistor LT may constitute a complementary field effect transistor (CFET) stack.

Example embodiments are described herein with reference to the accompanying drawings. Many different forms and embodiments are possible without deviating from the scope of the present inventive concept. Accordingly, the present inventive concept should not be construed as limited to the example embodiments set forth herein. Rather, these example embodiments are provided so that this disclosure will be thorough and complete and will convey the scope of the present inventive concept to those skilled in the art. In the drawings, the sizes and relative sizes of layers and regions may be exaggerated for clarity. Like reference numbers refer to like elements throughout.

Example embodiments of the present inventive concept are described herein with reference to cross-sectional views that are schematic illustrations of idealized embodiments and intermediate structures of example embodiments. As such, variations from the shapes of the illustrations as a result, for example, of manufacturing techniques and/or tolerances, are to be expected. Thus, example embodiments of the present inventive concept should not be construed as limited to the particular shapes illustrated herein but include deviations in shapes that result, for example, from manufacturing, unless the context clearly indicates otherwise.

Unless otherwise defined, all terms (including technical and scientific terms) used herein have the same meaning as commonly understood by one of ordinary skill in the art to which the present inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the present inventive concept. As used herein, the singular forms "a," "an" and "the" are intended to include the plural forms as well, unless the context clearly indicates otherwise. It will be further understood that the terms "comprises," "comprising," "includes" and/or "including," when used in this specification, specify the presence of the stated features, steps, operations, elements and/or components, but do not preclude the presence or addition of one or more other features, steps, operations, elements, components and/or groups thereof. As used herein the term "and/or" includes any and all combinations of one or more of the associated listed items.

It will be understood that although the terms first, second, etc. may be used herein to describe various elements, these elements should not be limited by these terms. These terms are only used to distinguish one element from another. Thus, a first element could be termed a second element without departing from the scope of the present inventive concept.

The above-disclosed subject matter is to be considered illustrative, and not restrictive, and the appended claims are intended to cover all such modifications, enhancements, and other embodiments, which fall within the scope of the inventive concept. Thus, to the maximum extent allowed by law, the scope is to be determined by the broadest permissible interpretation of the following claims and their equivalents and shall not be restricted or limited by the foregoing detailed description.

## Claims

1. A method of forming an integrated circuit device, the method comprising:
providing a preliminary transistor stack that comprises:
an upper sacrificial layer on a substrate;
an upper active region between the substrate and the upper sacrificial layer;
a lower sacrificial layer between the substrate and the upper active region; and
a lower active region between the substrate and the lower sacrificial layer;
forming lower source/drain regions on respective opposing side surfaces of the lower active region;
forming a capping layer on a first lower source/drain region of the lower source/drain regions, the capping layer comprising an insulating material; and
forming upper source/drain regions on respective opposing side surfaces of the upper active region.

2. The method of Claim 1, wherein the capping layer contacts a portion of a surface of the first lower source/drain region of the lower source/drain regions and has a uniform thickness along the portion of the surface of the first lower source/drain region of the lower source/drain regions.

3. The method of Claim 1 or 2, wherein forming the capping layer comprises:
forming a preliminary capping layer on the first lower source/drain region of the lower source/drain regions; and
converting the preliminary capping layer to the capping layer.

4. The method of Claim 3, wherein the preliminary capping layer comprises a semiconductor material.

5. The method of Claim 3 or 4, wherein forming the preliminary capping layer comprises performing an epitaxial growth process using the first lower source/drain region of the lower source/drain regions as a seed layer.

6. The method of any one of Claims 3 to 5, wherein converting the preliminary capping layer comprises performing an oxidation process and/or a nitridation process on the preliminary capping layer.

7. The method of Claim 6, wherein performing the oxidation process and/or the nitridation process comprises performing a plasma oxidation and/or a plasma nitridation using a gas comprising oxygen, nitrogen and/or ammonia.

8. The method of any one of Claims 3 to 7, wherein the preliminary capping layer comprises a silicon layer or a silicon germanium layer.

9. The method of any one of Claims 3 to 8, wherein the first lower source/drain region of the lower source/drain regions and the preliminary capping layer are formed by a single epitaxial process using the lower active region as a seed layer.

10. The method of any one of Claims 1 to 9, wherein the capping layer comprises a silicon oxide layer, a silicon oxynitride layer, a silicon nitride layer, a silicon germanium nitride layer or a germanium nitride layer.

11. The method of any one of Claims 1 to 10, wherein the capping layer has a uniform thickness on a surface of the first lower source/drain region of the lower source/drain regions.

12. The method of any one of Claims 1 to 11, wherein the preliminary transistor stack further comprises gate liner layers on the respective opposing side surfaces of the upper active region, and
the method further comprises removing the gate liner layers before forming the upper source/drain regions.

13. The method of any one of Claims 1 to 12, wherein the preliminary transistor stack further comprises:
upper inner spacers contacting respective opposing side surfaces of the upper sacrificial layer; and
lower inner spacers contacting respective opposing side surfaces of the lower sacrificial layer.

14. The method of any one of Claims 1 to 13, wherein a first upper source/drain region of the upper source/drain regions contacts the capping layer.
